# EUROPÄISCHE PATENTANMELDUNG

(11) **EP 3 561 981 A1**
(43) Veröffentlichungstag der Anmeldung: **30.10.2019**
(21) Anmeldenummer: 18169794.7
(22) Anmeldetag: 27.04.2018
(51) Int. Cl.: H02H 9/00, H03K 17/082, H02H 9/02, H03K 17/08

(54) **VERFAHREN ZUR REDUKTION EINES TEMPERATURANSTIEGS BEI EINEM STEUERBAREN SCHALTELEMENT**

(71) Anmelder: Siemens Aktiengesellschaft, 80333 München (DE)
(72) Erfinder: Troyer, Markus, 3040 Neulengbach (AT)
(74) Vertreter: Maier, Daniel Oliver

(57) **Zusammenfassung**

Die Erfindung betrifft ein Verfahren zur Reduktion eines Temperaturanstiegs bei einem Schaltelement (SE) einer elektronischen Sicherung (SI) bei Anschalten einer Last (L). Das Schaltelement (SE) wird durch ein Ansteuersignal (AS) angesteuert, durch welches ein maximal möglicher Stromanstieg eines in die Last (L) fließenden Ausgangsstroms (I_{A}) am Schaltelement (SE) begrenzt wird. Dabei wird ein zeitlicher Verlauf zumindest von einer an der Last anliegenden Ausgangsspannung (U_{A}), des in die Last fließenden Ausgangsstroms (I_{A}) und/oder einer Temperatur des Schaltelements (SE) ermittelt (102). Weiterhin werden die folgenden Schritte durchlaufen:
a. Einschalten des Schaltelements (SE, 101), wobei für eine Einschaltdauer des Schaltelements (SE) und/oder für einen Ausschaltstrom sowie für eine Ausschaltdauer des Schaltelements (SE) Vorgabewerte vorgegeben werden (100, 110);
b. Ausschalten des Schaltelements (SE) bei zumindest Erreichen eines Vorgabewertes des Ausschaltstroms oder der Einschaltdauer (106);
c. neuerliches Einschalten des Schaltelements (SE) nach Erreichen des Vorgabewertes der Ausschaltdauer (108), wobei die Schritte a und b durchlaufen werden, bis die Ausgangsspannung (U_{A}) einen Wert erreicht, welcher in Bezug auf die Eingangsspannung der elektronischen Sicherung (SI) eine vorgebbare Differenz unterschreitet, oder bis der Ausgangsstrom (I_{A}) einen vorgebbaren Dauerstrom (I_{L}) erreicht. Die Vorgabewerte von Einschaltdauer und/oder Ausschaltstrom sowie Ausschaltdauer werden beibehalten, bis auf Basis des Verlaufs von Ausgangsspannung (U_{A}), Ausgangsstrom (I_{A}) und/oder Temperatur neue Vorgabewerte bestimmt wurden (103) .

## Beschreibung

### Technisches Gebiet

Die gegenständliche Erfindung betrifft allgemein das Gebiet der Elektrotechnik, insbesondere den Bereich der Leistungselektronik sowie leistungselektronischer Schaltungen. Im Speziellen bezieht sich die vorliegende Erfindung auf ein Verfahren zur Reduktion bzw. Begrenzung eines Temperaturanstiegs in einem steuerbaren Schaltelement einer elektronischen Sicherung beim Anschalten einer Last, insbesondere einer Last mit kapazitivem Anteil bzw. einer kapazitiven Last. Dabei wird das Schaltelement mittels eines Ansteuersignals angesteuert.

### Stand der Technik

Elektronische Sicherungen werden heutzutage bei einer Vielzahl an Geräten, insbesondere zwischen einer Spannungs- und/oder Stromversorgung und einer elektrischen Last, als Schutzvorrichtung eingesetzt. Durch eine elektronische Sicherung wird beispielsweise bei einem Kurzschluss oder einer Überlastung sicher und schnell ein Stromfluss in die derart abgesicherte Last bzw. Komponente (z.B. eine Steuerung, eine speicherprogrammierbare Schaltung, ein Prozessor, etc.) unterbrochen, um diese Last sowie zugehörige Zuleitungen vor Beschädigung oder Zerstörung zu schützen. Dazu umfasst eine elektronische Sicherung üblicherweise ein Schaltelement - meist einen Halbleiter-basierten Schalter, durch welchen der Stromkreis unterbrochen wird. Eine derartige elektronische Sicherung bzw. Überwachungseinheit für Stromversorgungen ist beispielsweise aus der Schrift EP 1 236 257 B1 bekannt.

Bei elektrischen Lasten mit kapazitiven Anteil bzw. bei kapazitiven Lasten können bei betriebsmäßigem Einschalten bzw. Anschalten dieser Last an eine Spannungs- und/oder Stromversorgungsquelle (zumeist eine Gleichspannungsquelle) durch den kapazitiven Anteil Einschaltströme verursacht werden. Die kapazitiven Anteile der Last bzw. eine kapazitive Last stellt dabei einen idealen Kondensator dar, welcher beim Anlegen eines Spannungssprungs wie z.B. beim Anschalten an die Spannungsversorgung einen theoretisch gemäß der Formel i_{c}(t) = C*dU/dt unendlichen Stromimpuls zur Folge hat bzw. im Einschaltmoment einen idealen Kurzschluss darstellen kann. In der Praxis werden derartige Stromimpulse beispielsweise zumindest durch die parasitären, ohmschen Anteile der Leitungen, ohmsche Anteile des Schaltelements, einen äquivalenten Serienwiderstand (ESR), in welchem die ohmschen Leitungs- und die dielektrischen Umpolungsverluste des Kondensators zusammengefasst sind, etc. begrenzt. Allerdings können derartige Einschaltströme immer noch Werte erreichen, durch welche es z.B. vor allem aufgrund einer thermischen Belastung zu Schäden am Schaltelement kommen kann oder bei welchen eine gegebenenfalls optionale, weitere Schutzvorrichtung (z.B. Schmelzsicherung, etc.) der elektronischen Sicherung ungewollt zum Auslösen gebracht wird.

Um eine Beschädigung des Schaltelements oder ein ungewolltes Auslösen einer gegebenenfalls optionalen, weiteren Schutzvorrichtung der elektronischen Sicherung beim Anschalten insbesondere einer Last mit kapazitivem Anteil zu verhindern, ist es notwendig, die Einschaltströme entsprechend zu begrenzen - d.h. die Einschaltströme werden beispielsweise durch entsprechende Beschaltung des Schaltelements auf einen Wert begrenzt, welcher für das Schaltelement keine Gefahr darstellt bzw. welcher unterhalb eines Abschaltstromwertes einer gegebenenfalls vorhandenen, zusätzlichen Sicherungsvorrichtung (z.B. zusätzliche Schmelzsicherung) liegt.

Dazu wird das Schaltelement beispielsweise derart beschaltet, dass es z.B. als gesteuerte Stromquelle eingesetzt wird - d.h. bei Verwendung eines Transistors (z.B. MOS-FETs) als Schaltelement wird der Transistor im so genannten Linearbetrieb betrieben. Bei Linierbetrieb ist der Transistor weder völlig gesperrt noch völlig durchgeschaltet. Durch die entsprechende Beschaltung bzw. das Betreiben des Schaltelements im Linearbetrieb wird beispielsweise der Spannungssprung beim Anschalten der Last in einen konstanten Strom gewandelt, über welchen der kapazitive Lastanteil aufgeladen wird, bis sich ein betriebsmäßiger Ausgangs- bzw. Laststrom einstellt. Dazu ist beispielsweise aus der Schrift US 6,225,797 B1 eine Schaltung zur Begrenzung eines Einschaltstroms durch einen Transistor bekannt. Allerdings hat sich dabei vor allem einen Dimensionierung des Schaltelements bzw. des Transistors als schwierig erwiesen. Für einen Einsatz in der Praxis sind insbesondere leistungsfähige Bauteile notwendig, von welchen die Erfordernisse einer industriellen Anwendung erfüllt werden, aber deren Kosten immer noch ein vertretbares Maß aufweisen müssen.

Aus der Schrift EP 1 384 303 B1 ist daher eine Stromversorgung mit Abschaltsicherung bekannt, bei welcher die Einschaltströme auf parallele Zweige und damit die Verlustenergie auf zwei Schaltelemente im Linearbetrieb verteilt werden. Dabei weist einer der beiden Zweige einen zusätzlichen Leistungswiderstand zur Strombegrenzung auf. Um z.B. eine thermisch günstige Lastaufteilung zu erzielen, muss die Ansteuerung der Schaltelemente entsprechend gestaltet werden und die Schaltung weist damit eine relativ aufwendige und komplexe Schaltungstopologie auf.

Eine weitere Möglichkeit Einschaltströme zu begrenzen und zusätzlich das Schaltelement vor thermischer Belastung zu schonen, stellen beispielsweise zusätzlich in die Schaltung eingebrachte Impedanzen dar. Dazu können beispielsweise so genannte Heißleiter oder NTC-Widerstände eingesetzt werden, welche z.B. in Serie zum Schaltelement angebracht werden. Durch einen Heißleiter bzw. NTC-Widerstand, welcher seine Leitfähigkeit mit steigender Temperatur verändert, kann beispielsweise im Einschaltmoment hochohmig einen hohen Einschaltstrom verringern. Im weiteren Verlauf wird er durch aufgenommene Verlustenergie niederohmig und kann den sich im Normalbetrieb einstellenden Dauerstrom leiten. Alternativ können z.B. auch so genannte Kaltleiter bzw. PTC-Widerstände seriell zum Schaltelement für einen Strombegrenzung im Einschaltmoment eingesetzt werden. Die Kaltleiter weisen allerdings den Nachteil auf, dass diese für einen Normalbetrieb aufgrund ihres Leitverhaltens vor allem bei hohen Temperaturen z.B. mittels eines Parallelpfades (z.B. bestehend aus einem Transistor oder Relais) deaktiviert werden müssen. Ein weiterer Nachteil des Einsatzes von thermisch sensitiven Widerständen wie z.B. Heißleiter oder Kaltleiter besteht auch in der erforderlichen Baugröße. Damit der thermisch sensitive Widerstand eine bei relativ hohen Einschaltströmen auftretende und abzuleitende Verlustenergie aufnehmen kann, sich zumeist relativ große Widerstandsdurchmesser notwendig. Die Herstellung solcher thermisch sensitiven Widerstände ist allerdings relativ aufwendig und kostenintensiv.

Weiterhin können die Einschaltströme mittels einer Beschaltung des Schaltelements derart begrenzt werden, dass eine Beschädigung des Schaltelements durch Vorgabe einer Grenztemperatur oder eines vorgegebenen Temperaturhubs verhindert wird. D.h. der sich durch die Begrenzung ergebende Strom würde zwar nach einer Begrenzungszeit das Schaltelement thermisch überlasten, aber durch Vorgabe einer Grenztemperatur bzw. eines zulässigen Temperaturhubs wird das Schaltelement abgeschaltet, bevor z.B. eine Beschädigung des Schaltelements eintreten kann.

Aus der Schrift DE 203 02 275 U1 ist beispielsweise ein elektronischer Schalter bekannt, bei welchem mittels einer Regeleinrichtung ein Strom durch einen MOS-FET auf einen vorgegebenen Referenzwert begrenzt wird. Dabei wird zusätzlich die Temperatur des MOS-FETs überwacht und der Schalter bei Überschreiten eines vorgegebenen Temperaturwertes abgeschaltet.

Auch aus der Schrift DE 10 2012 103 551 B4 ist beispielsweise eine elektronische Sicherungsvorrichtung sowie ein elektronisches Sicherungsverfahren bekannt, bei welchem anhand einer Ausgangsspannung der elektronischen Sicherungsvorrichtung, welche an einer angeschlossenen Last anliegt, nach Auslösen der Sicherung bzw. nach Öffnen des Schaltelements festgestellt wird, ob ein Kurzschluss oder nur kurzzeitige Stromimpulse aufgrund von Einschaltströmen bzw. des Ladens einer kapazitiven Last vorliegen. Dazu wird die Differenz zwischen einer vor und nach dem Öffnen des Schaltelements gemessenen Ausgangsspannung mit einem Schwellwert verglichen und das Schaltelement wieder geschlossen, wenn die Differenz den Schwellwert übersteigt. Dabei kann auch eine Temperaturbestimmungsvorrichtung vorgesehen sein, welche anhand eines Ausgangsstroms die Temperatur des Schaltelements und/oder einer Schmelzsicherung abgeschätzt. Diese Information wird dann von einer Steuereinrichtung verwendet, um zu prüfen, ob die Temperatur unterhalb einer vorgegebenen Temperaturschwelle liegt, und um damit eine dauerhafte Überlast oder eine Beschädigung des Schaltelements und/oder der Schmelzsicherung durch Öffnen des Schaltelements zu verhindern.

Sowohl der elektronische Schalter aus der Schrift DE 203 02 275 U1 als auch die elektronische Sicherung aus der Schrift DE 10 2012 103 551 B4 bleiben bei Überschreiten der vorgegebenen Temperaturschwelle ausgeschaltet. Es ist aber z.B. möglich, das Schaltelement nach einer definierten Abkühlzeit wieder einzuschalten, bis z.B. die vorgegebene Temperaturschwelle wieder erreicht wird. Durch ein derartiges wiederholtes Ein- und Ausschalten des Schaltelements wird beispielsweise der kapazitive Anteil der Last geladen. Die Einschaltstromspitzen bzw. die Stromimpulse beim Einschalten des Schaltelements werden dadurch reduziert, bis sich ein betriebsmäßiger Dauerstrom - wie z.B. der am Ausgang der elektronischen Sicherung vorgegebenen Strom oder der Nennstrom - einstellt. Zum Abführen der durch die Stromimpulse entstehende Verlustenergie bzw. Wärmeenergie werden z.B. parasitäre ohmsche Anteile von Leitungen, Klemmen, der äquivalenten Serienwiderstand (ESR), etc. genutzt, wobei durch die zeitliche Begrenzung der Energieimpulse vorerst nur unmittelbar am Stromfluss beteiligte Teile des Schaltelements die Verlustenergie bzw. die entstehende Wärme aufnehmen können. Es entstehen damit relativ große Temperaturhübe, durch welche das Schaltelement einem relativ großen thermischen Stress ausgesetzt ist. Dadurch kann beispielsweise die Lebensdauer des Schaltelements, aber auch anderer Bauelemente der elektronischen Sicherung erheblich verkürzt werden - insbesondere Halbleiter-basierte Schaltelemente altern beispielsweise aufgrund der thermischen Belastung wesentlich rascher.

### Darstellung der Erfindung

Der Erfindung liegt daher die Aufgabe zugrunde, ein Verfahren anzugeben, durch welches auf einfache und kostensparende Weise eine thermische Belastung einer elektronischen Sicherung, insbesondere eines Schaltelements, bei Anschalten einer Last, insbesondere einer kapazitiven Last, reduziert und eine Lebensdauer der elektronischen Sicherung wesentlich erhöht wird.

Diese Aufgabe wird durch ein Verfahren der eingangs genannten Art mit den Merkmalen gemäß dem unabhängigen Patentanspruch gelöst. Vorteilhafte Ausführungsformen der vorliegenden Erfindung sind in den abhängigen Ansprüchen beschrieben.

Erfindungsgemäß erfolgt die Lösung der Aufgabe durch ein Verfahren der eingangs erwähnten Art, bei welchem ein Schaltelement einer elektronischen Sicherung mittels eines Ansteuersignals angesteuert wird und durch dieses Ansteuersignal ein maximal möglicher Stromanstieg eines in die Last fließenden Ausgangsstroms am Schaltelement begrenzt wird. Es wird ein zeitlicher Verlauf von zumindest einer an der Last anliegenden Ausgangsspannung und/oder des in die Last fließenden Ausgangsstroms und/oder einer Temperatur des Schaltelements ermittelt. Dabei werden die folgenden Schritte durchlaufen:
a. Einschalten des Schaltelements, wobei für eine Einschaltdauer des Schaltelements und/oder einen Ausschaltstrom sowie für eine Ausschaltdauer des Schaltelements Vorgabewerte vorgegeben werden;
b. Ausschalten des Schaltelements bei zumindest Erreichen bzw. bei Überschreiten des Vorgabewertes des Ausschaltstroms oder der Einschaltdauer;
c. neuerliches Einschalten des Schaltelements bei Erreichen des Vorgabewertes der Ausschaltdauer.

Dabei werden die Schritte a bis b durchlaufen, bis vom ermittelten Verlauf der Ausgangsspannung ein Wert erreicht wird, bei welchem in Bezug auf eine Eingangsspannung der elektronischen Sicherung eine vorgebbare Differenz unterschritten wird - d.h., dass von einer Differenz aus Eingangsspannung und ermittelter Ausgangsspannung der elektronischen Sicherung eine vorgebbare Differenz bzw. ein vorgebbarer Schwellwert unterschritten wird. Alternativ kann ein Durchlaufen der Schritt a bis b beendet werden, wenn vom ermittelten Verlauf des Ausgangsstroms ein vorgebbarer, maximaler Dauerstrom unterschritten wird. Beim wiederholten Durchlaufen der Schritte a bis b werden weiterhin die Vorgabewerte für die Einschaltdauer des Schaltelements und/oder Ausschaltstrom sowie der Vorgabewert für die Ausschaltdauer des Schaltelements solange beibehalten, bis auf Basis des ermittelten Verlaufs der Ausgangsspannung und/oder des Ausgangsstroms und/oder der Temperatur des Schaltelements neue Vorgabewerte für die Einschaltdauer des Schaltelements und/oder Ausschaltstrom und Ausschaltdauer des Schaltelements ermittelt wurden.

Der Hauptaspekt der erfindungsgemäß vorgeschlagenen Lösung besteht darin, dass durch das Ansteuersignal ein Stromanstieg und damit ein Temperaturanstieg beim Anschalten der Last verlangsamt und begrenzt wird. D.h. das Schaltelement wird so angesteuert, dass begonnen wird, das Schaltelement anfänglich in einem Linearbetrieb anzusteuern. Dabei wird der beim Anschalten einer Last, insbesondere mit kapazitivem Anteil, auftretende Stromimpuls in seiner Amplitude begrenzt und seine Flankensteilheit reduziert. Durch entsprechende Vorgabewerte für Ausschaltstrom bzw. Einschaltdauer, bei welchen das Schaltelement ausgeschaltet wird, wird ein Stromimpuls so kurz gehalten, dass der Temperaturanstieg bzw. der Temperaturhub im Schaltelement möglichst gering gehalten wird. Dadurch kann die im Schaltelement umgesetzte Verlustenergie, welche durch das Laden der kapazitiven Anteile der Last entsteht, auf eine größere thermische Masse verteilt werden. D.h. die beim Anschalten der Last mit kapazitivem Anteil in Form von Wärme entstehende Verlustenergie kann effizienter vom Schaltelement an die unmittelbare Umgebung wie z.B. Gehäuse und in weiterer Folge an Kühleinrichtungen (z.B. Kühlkörper, Kupferflächen, etc.) abgegebenen werden. Damit kann vom Schaltelement insgesamt mehr Verlustenergie aufgenommen und so beispielsweise eine Last mit größerem kapazitiven Anteil geschaltet werden, ohne dass das Schaltelement z.B. beschädigt wird. Durch die Reduktion des Temperaturanstiegs sowie einer damit verbundenen effizienteren Verteilung der Verlustenergie bzw. der entstandenen Wärme wird die Lebensdauer des Schaltelements bzw. der elektronischen Sicherung erhöht.

Zusätzlich wird auch eine gegebenenfalls optional vorhandene zusätzliche Schutzvorrichtung (z.B. Schmelzsicherung) entlastet sowie deren Dimensionierung vereinfacht. Eine solche zusätzliche Schutzvorrichtung sollte im Fehlerfall (z.B. Kurzschluss, etc.) entsprechend den Anforderungen beispielsweise zum Schutz der Kabel, etc. auslösen, aber im Fall von Einschaltstromspitzen nicht ansprechen. Durch die Reduktion der Stromamplituden beim Ein- bzw. Anschaltvorgang der Last können für eine derartige Schutzvorrichtung kostengünstigere Varianten bzw. Produkte verwendet werden.

Weiterhin wird durch das langsamere Ansteigen des Ausgangsstroms im Schaltelement Zeit gewonnen, um parallel zum Schalten des Schaltelements einen zeitlichen Verlauf des Ausgangsstroms und/oder der Ausgangsspannung und/oder gegebenenfalls der Temperatur des Schaltelements ermitteln zu können. Aus dem jeweils ermittelten, zeitlichen Verlauf können dann neue Vorgabewerte für Ausschaltstrom und/oder Einschaltdauer und Ausschaltdauer des Schaltelements abgeleitet sowie das Ansteuersignal an die neuen Gegebenheiten angepasst werden. Da sich aufgrund des Ladens der kapazitiven Lastanteile die Einschaltstromspitzen reduzieren - bis bei vollständiger Ladung der kapazitiven Lastanteile ein vorgebbarer, maximaler Dauerstrom erreicht wird, können die Vorgabewerte entsprechend angepasst werden. D.h. die Einschaltdauer des Schaltelements kann beispielsweise verlängert und/oder der Ausschaltstrom z.B. erhöht sowie und die Ausschaltdauer des Schaltelements z.B. verkürzt werden.

Weiterhin kann ein Anschalten einer rein ohmschen Last mit Hilfe des erfindungsgemäßen Verfahrens durch das Ermitteln des zeitlichen Verlaufs insbesondere der Ausgangsspannung sehr rasch - d.h. idealerweise bereits beim ersten Schaltzyklus des Schaltelements - erkannt werden. Zusätzlich lässt sich mittels des erfindungsgemäßen Verfahrens auch ein Kurzschluss in wenigen Schaltzyklen des Schaltelements leicht erkennen.

Für ein Ermitteln der neuen Vorgabewerte von Einschaltdauer und/oder Ausschaltstrom sowie Ausschaltdauer ist es günstig, wenn der jeweils ermittelte, zeitliche Verlauf der Ausgangsspannung, des Ausgangstroms und/oder der Temperatur des Schaltelements gemittelt wird. Dabei wird der jeweilige ermittelte, zeitliche Verlauf beispielsweise über eine Ermittlungsdauer der neuen Vorgabewerte gemittelt und damit z.B. brauchbare Werte für das Ermittlungsverfahren generiert. Ein Mitteln des jeweiligen zeitlichen Verlaufs kann beispielsweise mittels mathematischer Methoden wie z.B. Bildung von arithmetischen Mittelwerten, Bildung von Effektivwerten, etc. erfolgen. Alternativ kann das Mitteln z.B. auch durch Filterung (z.B. mittels eine Tiefpassfilters oder Hochpassfilters beliebiger Ordnung) oder durch Ausschluss oder Auswahl bzw. Selektion von Werten aus dem jeweils ermittelten, zeitlichen Verlauf erfolgen

Weiterhin ist es von Vorteil, wenn erste Vorgabewerte für die Einschaltdauer und/oder den Ausschaltstrom sowie die Ausschaltdauer anhand eines thermischen Modells des Schaltelements bestimmt werden. Als thermisches Modell für das Schaltelement kann beispielsweise ein so genanntes Cauer-Netzwerk oder ein so genanntes Foster-Netzwerk verwendet werden, durch welche eine thermische Charakterisierung zumindest des Schaltelements oder der elektrischen Sicherung vorgenommen werden kann. Mit Hilfe dieser Netzwerke, in welchen thermisch relevante Schichten im Wärmepfad z.B. durch thermische Widerstände und Wärmekapazitäten dargestellt werden, können beispielsweise sehr rasch Tempertaturen in einem elektronischen System wie z.B. einem elektrischen Schaltelement abgeschätzt bzw. berechnet werden. Damit lassen sich anhand des thermischen Modells des Schaltelements beispielsweise sehr einfach erste Vorgabewerte für Einschaltdauer und/oder Ausschaltstrom sowie Ausschaltdauer des Schaltelements als Startwerte für das erfindungsgemäße Verfahren ermitteln, wobei z.B. thermische Gegebenheiten des jeweils in der elektronischen Sicherung verwendeten Schaltelements (z.B. Junction-Temperatur bei einem Transistor als Schaltelement, thermische Kapazitäten des Schaltelements, Weiterleitungsfähigkeit der Verlustenergie bzw. Wärme, etc.) abgeschätzt und berücksichtigt werden können.

Vom jeweiligen thermischen Modell kann idealerweise der durch das Ansteuersignal maximal mögliche Stromanstieg des Ausgangsstroms am Schaltelement berücksichtigt werden, wobei dieser Stromanstieg durch das Ansteuersignal vorgegeben bzw. begrenzt wird. Damit kann auf einfache Weise eine vom Stromanstieg abhängige Entwicklung der Verlustenergie bzw. Wärme im Schaltelement bzw. in der elektronischen Sicherung und eine Temperaturentwicklung den maximal möglichen Stromanstieg abgeschätzt werden. Insbesondere die ersten Vorgabewerte für die Einschaltdauer und/oder den Ausschaltstrom sowie die Ausschaltdauer als Startwerte für das erfindungsgemäße Verfahren können damit auf einen maximal möglichen Stromanstieg angepasst werden. Das Ansteuersignal kann dazu beispielsweise rampenförmig ausgestaltet sein und so eine Stromvorgabe am Schaltelement gesteuert werden.

Alternativ oder zusätzlich kann in Schritt b) der ermittelte zeitliche Verlauf der Temperatur des Schaltelements bzw. am Schaltelement mit einer vorgebbaren Grenztemperatur verglichen werden. Bei zumindest Erreichen oder Überschreiten dieser vorgebbaren Grenztemperatur wird das Schaltelement abgeschaltet. Die vorgebbare Grenztemperatur kann ebenfalls in vorteilhafter Weise anhand des thermischen Modells des Schaltelements ermittelt werden. Die Temperatur des Schaltelements kann dabei unmittelbar - d.h. direkt im Schaltelement - oder mittelbar an einem Gehäuse des Schaltelements bestimmt werden. Bei einer mittelbaren Temperaturbestimmung wird z.B. eine Temperatur am Gehäuse oder in einer direkten Umgebung des Schaltelements gemessen. Anhand der gemessenen Temperaturwerte kann dann auf eine Temperatur innerhalb des Schaltelements rückgeschlossen werden. Für eine direkte Temperaturbestimmung kann beispielsweise ein Schaltelement mit integrierter Temperaturmessung verwendet werden, bei welchem z.B. direkt eine Junction-Temperatur bestimmt wird. Durch die Nutzung der Temperatur des Schaltelements als Abschaltkriterium für das Schaltelement können sehr leicht Beschädigungen des Schaltelements verhindert werden.

Eine bevorzugte Ausgestaltung der Erfindung sieht vor, dass das Ansteuersignal aus einem Vorgabesignal abgeleitet wird. Dieses Vorgabesignal wird idealerweise aus dem jeweils ermittelten, zeitlichen Verlauf der Ausgangsspannung und/oder des Ausgangsstroms und/oder der Temperatur des Schaltelements ermittelt und in vorteilhafter Weise von einer Auswerteeinheit generiert. D.h. von der Auswerteeinheit werden anhand des zeitlichen Verlaufs der Ausgabespannung, des Ausgabestrom und/oder der Temperatur während des erfindungsgemäßen Verfahrens die neuen - an die jeweiligen Gegebenheiten (z.B. Ladezustand der kapazitiven Lastanteile, aktuelle Temperatur des Schaltelements, etc.) angepassten - Vorgabewerte ermittelt bzw. berechnet und anhand des Vorgabesignals an eine Ansteuereinheit weitergegeben. Von der Ansteuereinheit wird dann aus dem Vorgabesignal das Ansteuersignal für das Schaltelement (z.B. rampenförmiges Signal für Gate-Source-Spannung) erzeugt. Dabei wird der Ausgangsstrom, welcher durch das Schaltelement fließt, im Anstieg di(t)/dt und/oder im erreichten Stromwert derart begrenzt, dass der Temperaturanstieg idealerweise auf ein Minimum begrenzt bleibt.

Eine zweckmäßige Weiterbildung der Erfindung vor, dass zum Ermitteln des zeitlichen Verlaufs von zumindest der an der Last anliegenden Ausgangsspannung und/oder des in die Last fließenden Ausgangsstroms und/oder der Temperatur des Schaltelements eine Überwachungseinheit vorgesehen wird. In der Überwachungseinheit können z.B. in vorteilhafter Weise mittels unterschiedlicher Messeinheiten ermittelte Werte von Ausgangsspannung, Ausgangsstrom und/oder Temperatur zu zeitlichen Verläufen zusammengefasst und gegebenenfalls Mittelwerte z.B. über einen Berechnungszeitraum bestimmt werden. Die von der Überwachungseinheit ermittelten Verläufe und/oder Werte können dann zur weiteren Verwendung wie z.B. der Berechnung neuer Vorgabewerte an die Auswertewerteeinheit weitergeleitet werden.

Eine vorteilhafte Ausgestaltung des erfindungsgemäßen Verfahrens sieht vor, dass eine Impedanz zusätzlich in Serie zum Schaltelement angebracht wird. Durch Verwendung einer Impedanz, welche z.B. als ohmscher Widerstand mit fixer oder variabler Widerstandswert ausgeführt ist, kann der Stromanstieg beim Anschalten der Last zusätzlich gedämpft und verzögert werden. In der Folge wird dadurch auch der Temperaturanstieg im Schaltelement verlangsamt sowie eine strombegrenzende Wirkung von z.B. parasitären Verlusten (z.B. Leitungsverluste, Innenwiderstand des Schaltelements, etc.) verstärkt. Alternativ kann die Impedanz auch als Induktivität ausgestaltet sind, durch welche beim Einschalten des Schaltelements ein zu rascher Stromanstieg verhindert wird.

Als Schaltelement kann in der elektronischen Sicherung idealerweise ein Transistor, insbesondere ein so genannter MetallOxid-Halbleiter-Feldeffekttransistor oder MOS-FET, verwendet werden. Ein MOS-FET gehört zu den Feldeffekttransistoren mit isoliertem Gate, bei welchem die Ansteuerung über eine Steuerspannung (Gate-Source-Spannung) als Ansteuersignal erfolgt. Der Einsatz eines MOS-FETs stellt eine einfache und kostengünstige Realisierung des Schaltelements dar, wobei MOS-FET eine relativ hohe Schaltgeschwindigkeit aufweisen können.

Eine spezielle Ausführungsvariante des erfindungsgemäßen Verfahrens sieht vor, dass das Schaltelement gemeinsam mit der Überwachungseinheit und der Ansteuereinheit als so genanntes integriertes Bauelement ausgeführt wird. Dadurch kann die Schaltung der elektronischen Sicherung einfacher gestaltet und die Baugröße weiter verringert werden.

### Kurzbeschreibung der Zeichnung

Die Erfindung wird nachfolgend in beispielhafter Weise anhand der beigefügten Figuren erläutert. Es zeigen beispielhaft:
Figur 1 eine elektronische Sicherung zur Durchführung des Verfahrens zur Reduktion eines Temperaturanstiegs bei einem Schaltelement
Figur 2 einen beispielhaften Ablauf des erfindungsgemäßen Verfahrens zur Reduktion eines Temperaturanstiegs bei einem Schaltelement bei Anschalten einer Last
Figur 3 beispielhaft und schematisch zeitliche Verläufe eines Ansteuersignals für das Schaltelement, eines Ausgangsstroms sowie einer Ausgangsspannung während des Ablaufs des erfindungsgemäßen Verfahrens

### Ausführung der Erfindung

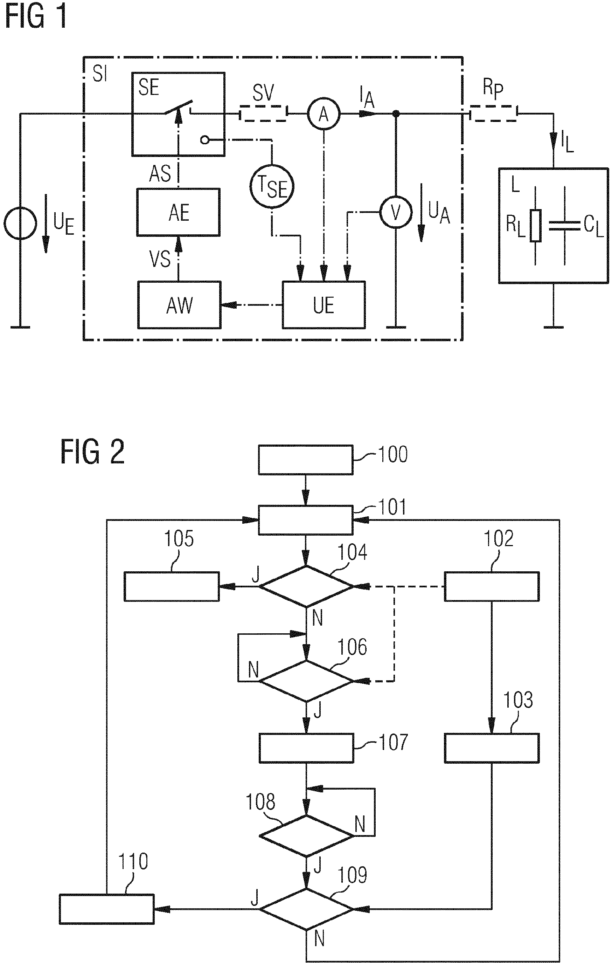

Figur 1 zeigt beispielhaft und in schematischer Weise eine elektronische Sicherung SI mit zumindest einem steuerbaren Schaltelement SE, welche zur Durchführung des erfindungsgemäßen Verfahrens zur Reduktion eines Temperaturanstiegs im Schaltelement SE eingerichtet ist. Die elektronische Sicherung SI kann beispielsweise als Schutzvorrichtung zwischen eine Versorgungsquelle, und eine elektrische Last L geschaltet werden. Als Versorgungsquelle wird beispielsweise eine Spannungsquelle verwendet, von welcher eine Eingangsspannung U_{E} geliefert wird. Die elektrische Last L umfasst beispielsweise einen ohmschen Anteil R_{L} und einen kapazitiven Anteil C_{L}, welcher beim Einschalten des Schaltelements SE der elektrischen Sicherung SI bzw. im Einschaltmoment zu relativ hohen Einschaltströmen führt. Weiterhin kann die elektrische Last z.B. auch einen induktiven Anteil aufweisen. An der Last L liegt eine Ausgangsspannung U_{A} der elektrischen Sicherung SI an und es fließt ein Ausgangsstrom I_{A} der elektrischen Sicherung SI in die Last L, wobei für einen laufenden Betrieb der Sicherung ein maximal zulässiger Dauerstrom I_{L} einstellbar ist. Dieser Dauerstrom I_{L} kann beispielsweise einem so genannten Nennstrom für die elektrische Last L entsprechen oder einen vorgebbaren, meist unterhalb des Nennstroms liegenden Wert annehmen.

Zusätzlich sind z.B. Leitungsverluste, Kupfer- und Leitungsverluste des Sicherung SI, Innenwiderstand der Versorgungsquelle, etc. als parasitärer, ohmscher Widerstand Rₚ dargestellt, durch welchen die Einschaltströme bzw. die Stromimpuls beim Einschalten zumindest geringfügig begrenzt werden. Für eine weitere Begrenzung der Einschaltströme kann beispielsweise eine mit dem Schaltelement SE in Serie angebrachte - in Figur 1 nicht dargestellte - Impedanz vorgesehen werden. Diese Impedanz kann z.B. als ohmscher Widerstand mit einem fixen oder variablen Widerstandswert (z.B. als Thermistor) ausgeführt sein. Alternativ kann für diese Impedanz auch eine Induktivität verwendet werden, durch welche ein zu rascher Stromanstieg beim betriebsmäßigen Einschalten des Schaltelements SE verhindert wird.

Die elektrische Sicherung SI kann neben dem steuerbaren Schaltelement SE optional eine zusätzliche Schutzvorrichtung SV aufweisen. Als zusätzliche Schutzvorrichtung SV kann beispielsweise eine Schmelzsicherung eingesetzt werden, welche im Fehlerfall (z.B. bei einem Kurzschluss, etc.) ansprechen soll, allerdings beim betriebsmäßigen Einschalten durch die entstehenden Stromimpulse bzw. Einschaltströme nicht zum Auslösen gebracht werden soll.

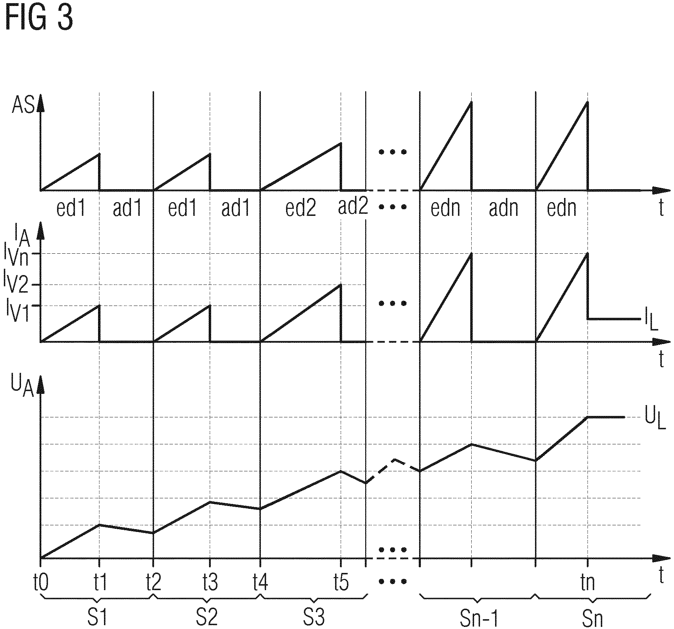

Als Schaltelement SE kann in der elektrischen Sicherung z.B. ein Transistor - insbesondere ein so genannter Metall-Oxid-Halbleiter-Feldeffekttransistor oder MOS-FET - eingesetzt werden. Idealerweise wird ein n-Kanal-MOS-FET verwendet. Das Schaltelement SE wird über ein Ansteuersignal AS angesteuert, welches bei einem MOS-FET als Schaltelement SE beispielsweise als so genannte Gate-Source-Spannung angelegt wird. Durch das Ansteuersignal AS wird außerdem ein maximal möglicher Stromanstieg di_{A}(t)/dt des in die Last L fließenden Ausgangsstroms I_{A} beim Anschalten der Last L begrenzt. Das Ansteuersignal AS wird aus einem Vorgabesignal VS mittels einer Ansteuereinheit AE erzeugt und ist beispielsweise - wie z.B. in Figur 3 dargestellt - rampenförmig ausgestaltet. Durch das Ansteuersignal AS wird der Stromanstieg di_{A}(t)/dt des in die Last L fließenden Ausgangsstroms I_{A} gesteuert, wobei die Rampenform bzw. eine Steigung des Ansteuersignals AS den Ausgangsstrom I_{A} durch das Schaltelement SE geregelt ansteigen lässt.

Das Vorgabesignal VS wird von einer Auswerteeinheit AW auf Basis eines zeitlichen Verlaufs des Ausgangsstroms I_{A} und/oder der Ausgangsspannung U_{A} und/oder einer Temperatur des Schaltelements SE ermittelt. D.h. für die Erzeugung des Vorgabesignals VS, welches auch Vorgabewerte wie z.B. Ausschaltdauer, Einschaltdauer und/oder Ausschaltstrom für das erfindungsgemäße Verfahren inkludiert, wird zumindest einer der zeitlichen Verläufe von Ausgangsstrom I_{A} oder Ausgangsspannung U_{A} oder Temperatur des Schaltelements SE als Führungsgröße herangezogen. Das Vorgabesignal VS kann als pulsweitenmoduliertes Rechtecksignal ausgestaltet sein und gibt beispielsweise durch die Berücksichtigung der Vorgabewerte die jeweilige Ausgestaltung des Ansteuersignals AS (z.B. Steigung und Länge der Rampenform) vor.

Für die Ermittlung der zeitlichen Verläufe von Ausgangsstrom I_{A} und/oder Ausgangsspannung U_{A} und/oder der Temperatur des Schaltelements SE wird eine Überwachungseinheit UE vorgesehen. Durch die Überwachungseinheit UE werden beispielsweise Messwerte von Ausgangsstrom I_{A} und/oder Ausgangsspannung U_{A} und/oder Temperatur des Schaltelements SE gesammelt, welche z.B. von entsprechenden Sensor- oder Messvorrichtungen T_{SE}, A, V ermittelt werden. Insbesondere kann dabei die Temperatur des Schaltelements SE - wie beispielhaft in Figur 1 dargestellt - unmittelbar direkt am Schaltelement SE bestimmt werden. Alternativ kann die Temperatur des Schaltelements SE auch mittelbar an einem Gehäuse des Schaltelements SE ermittelt werden. Dabei wird beispielsweise anhand einer gemessenen Gehäusetemperatur auf eine Temperatur des Schaltelements SE, vor allem auf die so genannte Junction-Temperatur zurückgeschlossen. Eine derartige Abschätzung der Temperatur des Schaltelements SE bzw. des zugehörigen, zeitlichen Verlaufs kann z.B. von der Überwachungseinheit UE vorgenommen werden.

Weiterhin kann das Schaltelement SE als integriertes Bauelement ausgeführt sein, wobei dieses integrierte Bauelement zumindest die Überwachungseinheit UE und die Ansteuereinheit AW sowie gegebenenfalls vorhandene Sensor- oder Messvorrichtungen T_{SE}, A, V für z.B. Temperatur, Strom und/oder Spannung umfassen kann.

Figur 2 zeigt beispielhaft einen bevorzugten Ablauf des erfindungsgemäßen Verfahrens zur Reduktion des Temperaturanstiegs bei einem steuerbaren Schaltelement SE einer elektrischen Sicherung SI wie beispielhaft in Figur 1 dargestellt. Das Verfahren beginnt mit einem Initialisierungs- oder Kalibrierungsschritt 100. Im Kalibrierungsschritt 100 werden anhand eines thermischen Modells des Schaltelements SE wie z.B. dem so genannten Cauer-Netzwerk oder dem so genannten Foster-Netzwerk erste Vorgabewerte für eine Einschaltdauer des Schaltelements SE und/oder einen Ausschaltstrom sowie für einen Ausschaltdauer des Schaltelements SE als Startwerte bestimmt.

Dabei können beispielsweise spezifische Parameter und/oder Vorgaben des jeweils in der elektrischen Sicherung SI verwendeten Schaltelements SE wie z.B. maximal zulässige Junction-Temperatur, etc. berücksichtigt werden. Weiterhin kann vom thermischen Modell der maximal mögliche Stromanstieg des Ausgangsstrom I_{A} und gegebenenfalls ein maximal zulässiger Temperaturhub der Junction-Temperatur abgeleitet werden. D.h. im Kalibrierungsschritt 100 werden aus dem thermischen Modell des Schaltelements SE für eine ungünstige Kombination der ohmschen Anteile R_{L} und der kapazitiven Anteil C_{L} der Last L beispielsweise ein maximal möglicher bzw. zulässiger Stromanstieg di_{A}(t)/dt des Ausgangsstroms I_{A} oder gegebenenfalls ein maximal zulässiger Temperaturhub der Junction-Temperatur ermittelt. Daraus können dann z.B. die ersten Vorgabewerte für die Einschaltdauer und/oder einen Ausschaltstrom sowie für einen Ausschaltdauer des Schaltelements SE sowie das von der Auswerteeinheit AW generierte Vorgabesignal VS abgeleitet werden. Das Vorgabesignal VS - basierend auf den ersten Vorgabewerten - wird dann an die Ansteuereinheit AE weitergeleitet und daraus das erste Ansteuersignal AS für das Schaltelement SE z.B. als rampenförmiges Ansteuersignal AS erzeugt.

In einem Einschaltschritt 101 wird das Schaltelement SE angesteuert durch das Ansteuersignal AS eingeschaltet. Dabei wird das Schaltelement SE vom Ansteuersignal AS derart angesteuert, dass der in die Last L fließende Ausgangsstrom I_{A} bzw. der entsprechend Stromanstieg di_{A}(t)/dt beim Anschalten der Last L begrenzt wird, damit ein zeitlicher Verlauf der Junction-Temperatur des Schaltelements SE einen kritischen Wert der Junction-Temperatur nicht übersteigt bzw. keine Schädigung des Schaltelements SE eintritt. Parallel zum Einschaltschritt 101 wird in einem Messschritt 102 z.B. mit Hilfe von Sensor- oder Messvorrichtungen T_{SE}, A, V zumindest einer der zeitlichen Verläufe von Ausgangsstrom I_{A} und/oder Ausgangsspannung U_{A} und/oder Temperatur des Schaltelements SE mit Hilfe der Überwachungseinheit UE ermittelt.

Auf Basis der jeweils im Messschritt 102 ermittelten, zeitlichen Verläufe von Ausgangsstrom I_{A} und/oder Ausgangsspannung U_{A} und/oder Temperatur des Schaltelements SE werden dann in einem Ermittlungsschritt 103 z.B. von der Auswerteeinheit AW neue Vorgabewerte für die Einschaltdauer des Schaltelements SE und/oder den Ausschaltstrom sowie die Ausschaltdauer des Schaltelements SE bestimmt. Dazu können beispielsweise die jeweils ermittelten, zeitlichen Verläufe von Ausgangsstrom I_{A} und/oder Ausgangsspannung U_{A} und/oder Temperatur des Schaltelements SE gemittelt werden. Ein Mitteln der einzelnen ermittelten, zeitlichen Verläufe von Ausgangsstrom I_{A} und/oder Ausgangsspannung U_{A} und/oder Temperatur des Schaltelements SE kann beispielsweise mathematisch - z.B. durch Bildung des jeweiligen arithmetischen Mittels oder durch Bildung von Effektivwerten - erfolgen oder alternativ mittels Filterung (beispielsweise mit Tiefpass- oder Hochpassfiltern beliebiger Ordnung) oder mittels Ausschluss oder Selektion von ermittelten Werten aus dem jeweiligen zeitlichen Verlauf durchgeführt werden.

Weiterhin werden der Messschritt 102 sowie der Ermittlungsschritt 103 parallel zu bzw. weitgehend unabhängig von anderen Schritten zur Durchführung des erfindungsgemäßen Verfahrens durchgeführt. Es wird allerdings in einem Vorgabenprüfschritt 109 geprüft, ob von der Auswerteeinheit AW neue Vorgabewerte für die Einschaltdauer und/oder den Ausschaltstrom sowie die Ausschaltdauer bestimmt wurden.

In einem Abbruchsprüfschritt 104 wird dann geprüft, ob vom ermittelten, zeitlichen Verlauf der Ausgangsspannung U_{A} ein Wert erreicht wurde, bei welchem im Bezug auf die Eingangsspannung U_{E} der elektronischen Sicherung SI eine vorgebbare Differenz unterschritten wird. D.h. es wird beispielsweise geprüft, ob eine Differenz aus Eingangsspannung U_{E} und Ausgangsspannung U_{A} (z.B. einem Mittelwert aus dem ermittelten, zeitlichen Verlauf) einen vorgebbaren Toleranzwert unterschreitet. Alternativ kann im Abbruchsprüfschritt 104 auch geprüft werden, ob vom ermittelten, zeitlichen Verlauf des Ausgangsstroms I_{A} einen vorgebbaren, maximalen Dauerstrom I_{L} unterschritten wird. Auch dabei kann z.B. ein Mittelwert aus dem ermittelten, zeitlichen Verlauf des Ausgangsstroms I_{A} herangezogen werden. Wird entweder vom zeitlichen Verlauf der Ausgangsspannung U_{A} ein Wert erreicht, bei welchem im Bezug auf die Eingangsspannung U_{E} der elektronischen Sicherung SI eine vorgebbare Differenz unterschritten wird, oder vom zeitlichen Verlauf des Ausgangsstroms I_{A} einen vorgebbaren, maximalen Dauerstrom I_{L} unterschritten, so wird das erfindungsgemäße Verfahren in einem Endschritt 105 abgebrochen bzw. beendet. Der Abbruchsprüfschritt 104 kann beispielsweise von der Auswerteeinheit AW durchgeführt werden. Die zeitlichen Verläufe von Ausgangsspannung U_{A} bzw. Ausgangsstrom I_{A} können z.B. im Messschritt 102 bestimmt werden.

Sind die im Abbruchsprüfschritt 104 vorgegebenen Abbruchsbedingungen nicht erfüllt, so bleibt das Schaltelement SE solange eingeschaltet, bis in einem Schaltprüfungsschritt 106 festgestellt wird, dass der Vorgabewert der Einschaltdauer - z.B. bei einem ersten Schaltzyklus des Schaltelements SE der Startwert für die Einschaltdauer des Schaltelements SE - zumindest erreicht ist. Alternativ oder zusätzlich, kann im Schaltprüfungsschritt 106 auch geprüft werden, ob der Vorgabewert bzw. im ersten Schaltzyklus des Schaltelements SE der vorgegebene Startwert des Ausschaltstroms vom jeweiligen, im Messschritt 102 aktuell ermittelten Ausgangsstrom I_{A} zumindest erreicht oder überschritten wird. Der Schaltprüfschritt 106 kann beispielsweise von der Auswerteeinheit AW durchgeführt werden.

Weiterhin kann im Schaltprüfungsschritt 106 alternativ oder zusätzlich der im Messschritt 102 ermittelte, zeitliche Verlauf der Temperatur des Schaltelements SE mit einer vorgebbaren Grenztemperatur für das Schaltelement SE verglichen werden. Im Schaltprüfungsschritt 106 wird dann geprüft, ob die vorgebbare Grenztemperatur vom ermittelten Temperaturverlauf zumindest erreicht bzw. überschritten wird. Die vorgebbare Grenztemperatur für das Schaltelement SE kann beispielsweise aus dem thermischen Modell des Schaltelements SE abgeleitet werden.

Wird im Schaltprüfungsschritt 106 festgestellt, dass entweder der Vorgabewert der Einschaltdauer oder der Vorgabewert des Ausschaltstroms erreicht bzw. überschritten wurde, so wird in einem Ausschaltschritt 107 das Schaltelement SE ausgeschaltet. Zusätzlich oder alternativ kann auch ein Erreichen oder Überschreiten der vorgebbaren Grenztemperatur durch den ermittelten, zeitlichen Verlauf der Temperatur am Schaltelement SE zur Durchführung des Ausschaltschritts 107 bzw. zum Abschalten des Schaltelements SE führen.

Das Schaltelement SE bleibt dann solange ausgeschaltet, bis der Vorgabewert der Ausschaltdauer bzw. im ersten Schaltzyklus der Startwert bzw. erste Vorgabewert der Ausschaltdauer zumindest erreicht bzw. überschritten wird. Das Erreichen der vorgegebenen Ausschaltdauer wird in einem Ausschaltprüfschritt 108 überprüft. Ist die vorgegebene Ausschaltdauer erreicht, so kann im Vorgabenprüfschritt 109 ermittelt, ob neue Vorgabewerte für die Einschaltdauer und/oder den Ausschaltstrom sowie die Ausschaltdauer im Ermittlungsschritt 103 z.B. von der Auswerteeinheit AW auf Basis der ermittelten, zeitlichen Verlaufe von Ausgangsstrom I_{A} und/oder Ausgangsspannung U_{A} und/oder der Temperatur des Schaltelement SE bestimmt worden sind.

Wurden keine neuen Vorgabewerte ermittelt, so werden zumindest für den nächsten Schaltzyklus des Schaltelements SE bzw. Durchlauf des Verfahrens die bisherigen Vorgabewerte weiterhin verwendet. Das Schaltelement SE wird dann im Einschaltschritt 101 neuerlich eingeschaltet, wobei die Vorgabewerte und damit das Ansteuersignal AS unverändert bleiben.

Liegen neue Vorgabewerte für die Einschaltdauer und/oder den Ausschaltstrom sowie die Ausschaltdauer vor, so werden die bisherigen Vorgabewerte durch die neuen Vorgabewerte in einem Austauschschritt 110 ersetzt und für das Vorgabesignal VS genutzt bzw. mit diesem ausgegeben. D.h. das Vorgabesignal VS wird z.B. von der Auswerteeinheit AW auf Basis der neuen Vorgabewerte angepasst und über die Ansteuereinheit in ein neues bzw. angepasstes Ansteuersignal AS für das Schaltelement SE umgewandelt. Das Schaltelement SE wird dann im Einschaltschritt 101 mit dem angepassten Ansteuersignal AS eingeschaltet. Dadurch kann beispielsweise ein möglicher Stromanstieg di_{A}(t)/dt durch das Schaltelement SE verändert bzw. geregelt werden - wie beispielhaft in Figur 3 dargestellt.

Alternativ kann der Vorgabeprüfschritt 109 auch vor dem Ausschaltprüfschritt 108 durchgeführt werden. D.h. es werden vor der Prüfung, ob der Vorgabewert der Ausschaltdauer des Schaltelements SE im Ausschaltprüfschritt 108 erreicht ist, der Vorgabeprüfschritt 109 und gegebenenfalls bei Vorliegen neuer Vorgabewerte für Einschaltdauer und/oder Ausschaltstrom sowie Ausschaltdauer des Schaltelements DE der Austauschschritt 110 durchgeführt.

Das erfindungsgemäße Verfahren wird dann solange durchgeführt, bis im Abbruchsprüfschritt 104 festgestellt wird, dass eine der Abbruchsbedingungen erfüllt ist, und mit dem Endschritt 105 beendet, wobei das Schaltelement SE betriebsmäßig eingeschaltet bleibt.

In Figur 3 sind beispielhaft und schematisch eine zeitlicher Verlauf des Ansteuersignals AS für das Schaltelement SE sowie entsprechende, zeitliche Verläufe des Ausgangsstroms I_{A} und der Ausgangsspannung U_{A} während des Ablaufs mehrerer Wiederholungen des erfindungsgemäßen Verfahrens bis zu einem Abbruch bzw. Beendigung durch den Abbruchsprüfschritt 104 bzw. den Endschritt 105 dargestellt, wobei in einem obersten Diagramm der zeitliche Verlauf des Ansteuersignals AS, in einem mittleren Diagramm der zeitliche Verlauf des Ausgangsstroms I_{A} und in einem untersten Diagramm der zeitliche Verlauf der Ausgangsspannung U_{A} beispielhaft dargestellt sind. Auf der jeweiligen x-Achse ist dabei die Zeit t und auf der jeweiligen y-Achse sind das Ansteuersignal AS für das Schaltelement SE, ein entsprechender Verlauf des Ausgangsstroms I_{A} bzw. der Ausgangsspannung U_{A} aufgetragen. Es werden beispielhaft S1 bis Sn Durchläufe des erfindungsgemäßen Verfahrens bzw. S1 bis Sn Schaltzyklen vom Schaltelement SE durchlaufen.

Im Initialisierungsschritt 100 werden für das Verfahren auf Basis des thermischen Modells des Schaltelements SE ein erster Vorgabewert ed1 für die Einschaltdauer, ein erster Vorgabewert ad1 für die Ausschaltdauer und/oder ein erster Vorgabewert I_{V1} für den Ausschaltstrom vorgegeben. Im Einschaltschritt 101 wird das Schaltelement zu einem ersten Zeitpunkt t0 mittels des Ansteuersignals AS eingeschaltet und damit ein erster Schaltzyklus S1 gestartet. Das Ansteuersignal AS kann dazu eine Rampenform aufweisen. Dabei wird ein Stromanstieg di_{A}(t)/dt des Ausgangsstroms I_{A} durch das Schaltelement SE begrenzt - wie durch den im mittleren Diagramm beispielhaft dargestellten, zeitlichen Verlauf des Ausgangsstroms I_{A} gezeigt. D.h. der Strom durch das Schaltelement SE bzw. der Ausgangsstrom I_{A} steigt proportional zum bzw. geregelt durch das Ansteuersignal AS an.

Da durch die über das Schaltelement SE übertragene Energie der kapazitive Anteil C_{L} der Last L geladen wird, wird auch ein im untersten Diagramm dargestellter Anstieg der Ausgangsspannung U_{A} bewirkt. Analog zum Anstieg des Ausgangsstrom I_{A} steigt auch die Temperatur des Schaltelements SE sowie eine im Schaltelement SE umgesetzte Verlustenergie an.

Wird in einem zweiten Zeitpunkt t1 im Schaltprüfschritt 106 des ersten Schaltzyklus S1 festgestellt, dass entweder der erste Vorgabewert ed1 für die Einschaltdauer oder der erste Vorgabewert I_{V1} für den Ausschaltstrom erreicht bzw. überschritten wird, so wird das Schaltelement SE durch das Ansteuersignal AS im Ausschaltschritt 107 abgeschaltet. D.h. das Ansteuersignal AS wird wie im obersten Diagramm dargestellt beendet, wodurch wie im mittleren Diagramm dargestellt der Ausgangsstrom I_{A} durch das Schaltelement auf einen Wert 0 geht. Die Ausgangsspannung U_{A} sinkt wie im untersten Diagramm ab, da nach dem Abschalten des Schaltelements SE der kapazitiven Anteil C_{L} der Last L - beispielsweise durch den ohmschen Anteil R_{L} der Last L, wieder entladen wird. Weiterhin sinkt auch die Temperatur des Schaltelements SE ab, da während der Ausschaltdauer ad1 eine während der Einschaltdauer ed1 entstandene Wärme zumindest teilweise z.B. an die Umgebung wie z.B. Gehäuse und in weiterer Folge an Kühleinrichtungen (z.B. Kühlkörper, Kupferflächen, etc.) abgegeben werden.

Die Aufladung des kapazitiven Anteils C_{L} der Last bzw. das Ansteigen der Ausgangsspannung U_{A} hat zur Folge, dass weniger Verlustenergie im Schaltelement SE umgesetzt wird. D.h. die Vorgabewerte für Einschaltdauer und/oder Ausschaltstrom sowie Ausschaltdauer können für zumindest einen folgenden Schaltzyklus S2 und damit das Ansteuersignal AS angepasst werden. Dazu wird zumindest einer der zeitlichen Verläufe von Ausgangsstrom I_{A} und/oder Ausgangsspannung U_{A} und/oder Temperatur des Schaltelements SE herangezogen und es können von der Auswerteeinheit AW neue Vorgabewerte berechnet werden.

Nachdem im Ausschaltprüfschritt 108 festgestellt wurde, dass der erste Vorgabewert ad1 der Ausschaltdauer erreicht bzw. überschritten wurde, wird in einem dritten Zeitpunkt t2 das Schaltelement SE durch den Einschaltschritt 101 für einen zweiten Schaltzyklus S2 eingeschaltet. Da im Vorgabeprüfschritt 109 festgestellt wurde, dass z.B. noch keine neuen Vorgabewerte für Einschaltdauer und/oder Ausschaltstrom sowie Ausschaltdauer vorliegen bzw. von der Auswerteeinheit AW berechnet wurden, werden für den zweiten Schaltzyklus S2 die ersten Vorgabewerte ed1, ad1, I_{V1} weiter verwendet. D.h. wie im obersten Diagramm dargestellt, entspricht der Verlauf des Ansteuersignals AS im zweiten Schaltzyklus S2 dem Verlauf im ersten Schaltzyklus S1. Aus dem mittleren Diagramm ist wieder ersichtlich, dass der Ausgangsstrom I_{A} ebenfalls proportional dem Ansteuersignal ansteigt. Die Ausgangsspannung U_{A} steigt allerdings - wie im untersten Diagramm dargestellt - aufgrund der weiteren Aufladung des kapazitiven Anteils C_{L} der Last L im zweiten Schaltzyklus S2 weiter an.

Wird in einem vierten Zeitpunkt t3 im Schaltprüfschritt 106 des zweiten Schaltzyklus S2 festgestellt, dass entweder der erste Vorgabewert ed1 für die Einschaltdauer oder der erste Vorgabewert I_{V1} für den Ausschaltstrom erreicht bzw. überschritten wird, so wird das Schaltelement SE durch das Ansteuersignal AS im Ausschaltschritt 107 wieder abgeschaltet - bis in einem fünften Zeitpunkt t4 der erste Vorgabewert ad1 der Ausschaltdauer erreicht ist. Da beispielsweise nun im Vorgabeprüfschritt 109 festgestellt wurde, dass neuen Vorgabewerte ed2, I_{V2}, ad2 für Einschaltdauer und/oder Ausschaltstrom sowie Ausschaltdauer vorliegen bzw. von der Auswerteeinheit AW berechnet wurden, werden für einen dritten Schaltzyklus S3 im Austauschschritt 110 die neuen Vorgabewerte ed2, ad2, I_{V2} übernommen.

Auf Basis dieser neuen Vorgabewerte ed2, ad2, I_{V2} wird dann ein neues Vorgabesignal VS und damit ein neues Ansteuersignal AS - wie beispielhaft im obersten Diagramm für den dritten Schaltzyklus S3 - erzeugt. Mit dem neuen Ansteuersignal AS wird dann das Schaltelement SE im Einschaltschritt 101 wieder eingeschaltet. Das Schaltelement SE wird in einem sechsten Zeitpunkt t5 - bei Erreichen des neuen Vorgabewerts ed2 der Einschaltdauer oder bei Erreichen des neuen Vorgabewerts I_{V2} des Ausschaltstroms im Ausschaltschritt 107 wieder ausgeschaltet, bis der neue Vorgabewert ad2 der Ausschaltdauer erreicht ist.

Das Verfahren wird solange durchlaufen bis z.B. in einem n-ten Schaltzyklus des Schaltelements SE zu einem Zeitpunkt tn im Abbruchsprüfschritt 104 festgestellt wird, dass vom ermittelten, zeitlichen Verlauf der Ausgangsspannung U_{A} ein Wert erreicht wurde, bei welchem im Bezug auf die Eingangsspannung U_{E} der elektronischen Sicherung SI eine vorgebbare Differenz unterschritten wird. D.h. es stellt sich eine Ausgangsspannung U_{A} bzw. U_{L} ein, welche annähernd der Eingangsspannung U_{E} der elektrischen Sicherung SI entspricht. Alternativ kann im Abbruchsprüfschritt 104 auch geprüft werden, ob vom ermittelten, zeitlichen Verlauf des Ausgangsstroms I_{A} einen vorgebbaren, maximalen Dauerstrom I_{L} erreicht bzw. unterschritten wird. Der sich einstellende Ausgangsstrom I_{A} bzw. I_{L} entspricht dabei der sich einstellenden Ausgangsspannung U_{L} dividiert durch den ohmschen Anteil R_{L} der Last. Der kapazitive Anteil C_{L} der Last L ist zum Zeitpunkt tn vollständig aufgeladen. Wird entweder vom zeitlichen Verlauf der Ausgangsspannung U_{A} ein Wert erreicht, bei welchem im Bezug auf die Eingangsspannung U_{E} der elektronischen Sicherung SI eine vorgebbare Differenz unterschritten wird, oder vom zeitlichen Verlauf des Ausgangsstroms I_{A} einen vorgebbaren, maximalen Dauerstrom I_{L} erreicht bzw. unterschritten, so wird das erfindungsgemäße Verfahren in einem Endschritt 105 abgebrochen bzw. beendet und das Schaltelement SE bleibt für den laufenden Betrieb eingeschaltet.

## Patentansprüche

1. Verfahren zur Reduktion eines Temperaturanstiegs bei einem steuerbaren Schaltelement (SE) einer elektronischen Sicherung (SI) bei Anschalten einer Last (L), insbesondere einer kapazitiven Last (C_{L}), wobei das Schaltelement (SE) mittels eines Ansteuersignals (AS) angesteuert wird, **dadurch gekennzeichnet, dass** durch das Ansteuersignal (AS) ein maximal möglicher Stromanstieg eines in die Last (L) fließenden Ausgangsstroms (I_{A}) am Schaltelement (SE) begrenzt wird, dass ein zeitlicher Verlauf von zumindest einer an der Last (L) anliegenden Ausgangsspannung (U_{A}) und/oder des in die Last fließenden Ausgangsstroms (I_{A}) und/oder einer Temperatur des Schaltelements (SE) ermittelt wird (102), und dass dabei die folgenden Schritte durchlaufen werden:
a. Einschalten des Schaltelements (SE, 101), wobei für eine Einschaltdauer des Schaltelements und/oder einen Ausschaltstrom sowie für eine Ausschaltdauer des Schaltelements (SE) Vorgabewerte vorgegeben werden (100, 110);
b. Ausschalten des Schaltelements (SE) bei zumindest Erreichen des Vorgabewertes des Ausschaltstroms oder der Einschaltdauer (107);
c. neuerliches Einschalten des Schaltelements (SE) bei Erreichen des Vorgabewertes der Ausschaltdauer (109), wobei die Schritte a bis b durchlaufen werden, bis vom ermittelten Verlauf der Ausgangsspannung (U_{A}) ein Wert erreicht wird, bei welchem in Bezug auf eine Eingangsspannung (U_{E}) der elektronischen Sicherung (SI) eine vorgebbare Differenz unterschritten wird, oder vom ermittelten Verlauf des Ausgangsstroms (I_{A}) ein vorgebbarer, maximaler Dauerstrom (I_{L}) zumindest unterschritten wird (104, 105), und wobei die Vorgabewerte für die Einschaltdauer des Schaltelements (SE) und/oder Ausschaltstrom sowie der Vorgabewert für die Ausschaltdauer des Schaltelements (SE) beibehalten werden (109), bis auf Basis des ermittelten Verlaufs der Ausgangsspannung und/oder des Ausgangsstroms und/oder der Temperatur des Schaltelements neue Vorgabewerte ermittelt wurden (103).

2. Verfahren nach Anspruch 1, ***dadurch gekennzeichnet*, *dass*** für ein Ermitteln der neuen Vorgabewerte von Einschaltdauer und/oder Ausschaltstrom sowie Ausschaltdauer der jeweils ermittelte, zeitliche Verlauf der Ausgangsspannung (U_{A}), des Ausgangstroms (I_{A}) und/oder der Temperatur des Schaltelements (SE) gemittelt wird (103).

3. Verfahren nach einem der Ansprüche 1 bis 2, ***dadurch gekennzeichnet, dass*** erste Vorgabewerte für die Einschaltdauer und/oder den Ausschaltstrom sowie die Ausschaltdauer anhand eines thermischen Modells des Schaltelements (SE), insbesondere dem so genannten Cauer-Netzwerk oder dem so genannten Foster-Netzwerk, bestimmt werden (100).

4. Verfahren nach Anspruch 3, ***dadurch gekennzeichnet, dass*** vom thermischen Modell der durch das Ansteuersignal (AS) vorgegebene maximal mögliche Stromanstieg des Ausgangsstroms am Schaltelement (SE) berücksichtigt wird (100).

5. Verfahren nach einem der Ansprüche 1 bis 4, ***dadurch gekennzeichnet, dass*** weiterhin der ermittelte, zeitliche Verlauf der Temperatur des Schaltelements (SE) mit einer vorgebbaren Grenztemperatur verglichen wird, und dass das Schaltelement (SE) bei zumindest Erreichen dieser Grenztemperatur abgeschaltet wird (106).

6. Verfahren nach Anspruch 5, ***dadurch gekennzeichnet, dass*** die vorgebbare Grenztemperatur anhand des thermischen Modells des Schaltelements (SE) ermittelt wird (100).

7. Verfahren nach einem der vorangegangenen Ansprüche, ***dadurch gekennzeichnet, dass*** die Temperatur des Schaltelements (SE) mittelbar an einem Gehäuse des Schaltelements (SE) oder in einer direkten Umgebung des Schaltelements (SE) oder unmittelbar direkt im Schaltelement (SE) bestimmt wird (102).

8. Verfahren nach einem der vorangegangenen Ansprüche, ***dadurch gekennzeichnet, dass*** das Ansteuersignal (AS) aus einem Vorgabesignal (VS) abgeleitet wird, wobei das Vorgabesignal (VS) aus dem jeweils ermittelten, zeitlichen Verlauf der Ausgangsspannung (U_{A}), des Ausgangsstroms (I_{A}) und/oder der Temperatur des Schaltelements (SE) bestimmt wird.

9. Verfahren nach Anspruch 7, ***dadurch gekennzeichnet, dass*** das Vorgabesignal (VS) von einer Auswerteeinheit (AW) generiert wird.

10. Verfahren nach einem der Ansprüche 8 bis 9, ***dadurch gekennzeichnet, dass*** das Ansteuersignal (AS) von einer Ansteuereinheit (AE) aus dem Vorgabesignal (VS) erzeugt wird.

11. Verfahren nach einem der vorangegangenen Ansprüche, ***dadurch gekennzeichnet, dass*** zum Ermitteln des zeitlichen Verlaufs von zumindest der an der Last anliegenden Ausgangsspannung (U_{A}) und/oder des in die Last fließenden Ausgangsstroms (I_{A}) und/oder der Temperatur des Schaltelements (SE) eine Überwachungseinheit (UE) vorgesehen wird.

12. Verfahren nach einem der vorangegangenen Ansprüche, ***dadurch gekennzeichnet, dass*** eine Impedanz (Rp) zusätzlich in Serie zum Schaltelement (SE) angebracht wird.

13. Verfahren nach einem der vorangegangenen Ansprüche, ***dadurch gekennzeichnet, dass*** als Schaltelement (SE) ein Transistor, insbesondere ein so genannter MOS-FET, verwendet wird.

14. Verfahren nach einem der vorangegangenen Ansprüche, ***dadurch gekennzeichnet, dass*** das Schaltelement (SE) zumindest gemeinsam mit der Überwachungseinheit (UE) und der Ansteuereinheit (AE) als so genanntes integriertes Bauelement ausgeführt wird.
